# EUROPÄISCHE PATENTSCHRIFT

(11) **EP 1 254 461 B1**
(45) Veröffentlichungstag und Bekanntmachung des Hinweises auf die Patenterteilung: **23.05.2007**
(21) Anmeldenummer: 01903699.5
(22) Anmeldetag: 05.02.2001
(51) Int. Cl.: G11C 29/00

(54) **TESTBARER FESTWERTSPEICHER FÜR DATENSPEICHER-REDUNDANZLOGIK**
TESTABLE ROM CHIP FOR A DATA MEMORY REDUNDANT LOGIC
MEMOIRE MORTE TESTABLE POUR LOGIQUE REDONDANTE DE MEMOIRE DE DONNEES

(30) Priorität: 08.02.2000 US 500414
(43) Veröffentlichungstag der Anmeldung: 06.11.2002
(73) Patentinhaber: Infineon Technologies AG, 81669 München (DE)
(72) Erfinder: FLECK, Rod, Bellevue, WA 98006 (US); IENNE, Paolo, CH-1007 Lausanne/VD (CH); OBERLAENDER, Klaus, San Jose, CA 95122 (US); RANDHAWA, Sabeen, San Jose, CA 95125 (US); GAZIELLO, Laurent, F-06300 Nizza (FR); MARTELLONI, Yannick, 85586 Poing (DE); PAUL, Steffen, 82065 Baierbrunn (DE); SCHÖBER, Volker, 81543 München (DE)
(74) Vertreter: Charles, Glyndwr
(86) Internationale Anmeldenummer: PCT/EP2001/001211
(87) Internationale Veröffentlichungsnummer: WO 2001/059790

(56) Entgegenhaltungen:
- EP-A- 0 702 373
- US-A- 5 233 566
- US-A- 5 636 161
- US-A- 5 708 601

## Beschreibung

Die Erfindung betrifft einen testbaren Festwertspeicher für Datenspeicher-Redundanzlogik zum Abspeichern von in einem Testverfahren ermittelten Fehleradressen von fehlerhaften Datenspeichereinheiten innerhalb eines Hauptdatenspeichers.

Der zunehmende Speicherbedarf von Anwendungsprogrammen führt dazu, dass die Speichergrößen von Halbleiterspeichern in den letzten Jahren stark angestiegen ist. Mit zunehmender Speichergröße und mit dem damit verbundenen erhöhten Integrationsgrad bei der Herstellung von Halbleiterspeichern steigt die Wahrscheinlichkeit an, dass einzelne Datenspeichereinheiten des Halbleiterspeichers im Herstellungsprozess fehlerhaft hergestellt werden und somit funktionsuntüchtig sind. Damit der Ausfall vereinzelter Datenspeichereinheiten nicht dazu führt, dass der gesamte Halbleiterspeicher funktionsunfähig bzw. defekt ist, werden zunehmend in die Datenspeicher redundante Speicherbereiche miteingebaut. Derartige redundante Speicher enthalten einen Redundanz-Adressenspeicher mit mehreren Redundanz-Adressenspeichereinheiten sowie einen Redundanz-Datenspeicher mit Redundanz-Datenspeichereinheiten. Jede Redundanz-Adressenspeichereinheit ist einer Redundanz-Datenspeichereinheiten zugeordnet.

Wird in einem Testvorgang eine fehlerhafte Datenspeichereinheit innerhalb des Hauptdatenspeichers festgestellt, wird die Fehleradresse für fehlerhaften Datenspeichereinheit in eine Adressenspeichereinheit des Redundanz-Adressenspeichers eingeschrieben und im Falle eines Datenzugriffs auf diese Fehleradresse auf die zugeordnete Datenspeichereinheit innerhalb des Redundanz-Datenspeichers zugegriffen anstatt auf die fehlerhafte Datenspeichereinheit innerhalb des Haupt-Datenspeichers.

Durch diese Umadressierung ist es möglich, eine gewisse Anzahl von fehlerhaften Datenspeichereinheiten innerhalb des Haupt-Datenspeichers durch redundante Datenspeichereinheiten innerhalb des Redundanz-Datenspeichers zu ersetzen.

Der Zugriff auf den Redundanz-Adressenspeichers sowie auf den Redundanz-Datenspeicher wird durch eine in dem Datenspeicher integrierte Redundanz-Steuerlogik gesteuert. Der Redundanz-Adressenspeicher innerhalb der Redundanz-Steuerlogik wird durch Adressenregister gebildet, die im Falle eines Ausfalls der Stromversorgung dazu führen, dass die darin eingespeicherten Fehleradressen von fehlerhaften Datenspeichereinheiten innerhalb des Haupt-Datenspeichers verloren gehen.

Die im Testvorgang ermittelten Fehleradressen von fehlerhaften Datenspeichereinheiten werden daher zusätzlich in einen Festwertspeicher fest einprogrammiert, wobei die darin eingeschriebenen Fehleradressen im Bedarfsfall wieder in den Redundanz-Adressenspeicher eingeschrieben werden. Die Festwertspeicher bestehen dabei aus einer Vielzahl von Festwert-Speichereinheiten, die Adressen-BITS der Fehleradressen fest speichern.

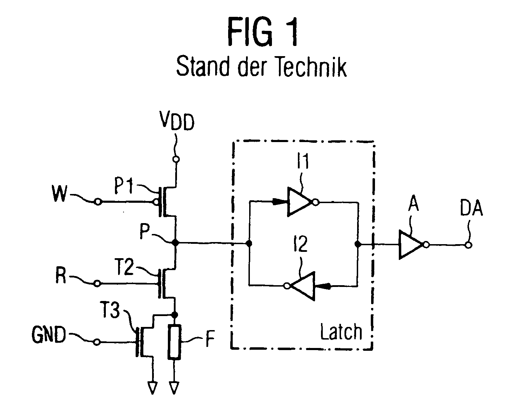

Fig. 1 zeigt eine Festwert-Speichereinheit nach dem Stand der Technik. Die Festwert-Speichereinheit enthält eine Schmelzsicherungseinrichtung F, in die ein BIT, beispielsweise ein-Adressen-BIT, nicht löschbar eingeschrieben werden kann. Die Schmelzsicherungseinrichtung F besteht in der Regel aus einem schmelzbaren Widerstand, der aus Metall oder Polysilizium besteht.

Durch Anlegen eines Steuersignals an einen Einschreibanschluss W wird ein an der Versorgungsspannung VDD anliegender P-Kanal MOSFET P1 durchgeschaltet, so dass der Potentialknoten P zum Verladen der Schmelzsicherungseinrichtung F vorgeladen werden kann.

Durch Anlegen eines Lesesignals R an das Gate des zu dem ersten MOSFET komplementären NIOSFETS T2 kann das in die Schmelzsicherungseinrichtung F eingeschriebene BIT ausgelesen werden.

Durch Anlegen eines Steuersignals GND an den Transistor T3 wird der in der Schmelzsicherungseinrichtung eingeschriebene Datenwert auf Masse gezogen und somit logisch 0.

Dem Potentialknoten P ist eine Latch-Verriegelungsschaltung nachgeschaltet, die aus zwei rückgekoppelten Inverterschaltkreisen I 1, I 2, besteht. Der Latch-Schaltung ist ein DatenAusgabepuffer A nachgeschaltet. Der Daten-Ausgabepuffer-A besteht ebenfalls aus einem Inverter.

Das aus der Schmelzsicherungseinrichtung F ausgelesene BIT liegt bei Anlegen eines Auslesesteuerbefehls am Anschluss R am Ausgang DA des Ausgangspuffers A an.

Die in Fig. 1 dargestellte Festwertspeichereinheit weist den Nachteil auf, dass sie bezüglich ihrer eigenen Funktionsfähigkeit nicht testbar ist.

Tritt ein schaltungstechnischer Fehler während der Herstellungsvorgangs des Festwertspeichers auf, liegt an dem Ausgang DA der Festwertspeichereinheit unter Umständen ein falscher logischer Wert an.

Hierdurch wird beispielsweise im Falle eines Stromausfalls und dem anschließenden Einschreiben der Fehleradressen aus dem Festwertspeicher in den Redundanz-Adressenspeicher der Redundanz-Steuerlogik eine falsche Adresse eingeschrieben. Die Umadressierung einer fehlerhaften Datenspeichereinheit innerhalb des Haupt-Datenspeichers auf eine Redundanz- Datenspeichereinheit innerhalb des Redundanz-Datenspeichers ist dann auf Dauer fehlerhaft.

In dem US-Patent 5,233,566 ist ein testbarer Festwertspeicher für eine Datenspeicher-Redundanzlogik beschrieben, die eine Festwertspeichereinheit zum Abspeichern von ermittelten Fehleradressen von fehlerhaften Datenspeichereinheiten aufweist.

Es ist daher die Aufgabe der vorliegenden Erfindung einen testbaren Festwertspeicher für eine Datenspeicher-Redundanzlogik zu schaffen, deren Funktionsfähigkeit selbst durch einen Testvorgang überprüfbar ist.

Diese Aufgabe wird erfindungsgemäß durch einen testbaren Festwertspeicher mit den im Patenanspruch 1 angegebenen Merkmalen gelöst.

Die Erfindung schafft einen testbaren Festwertspeicher für eine Datenspeicher-Redundanzlogik mit Festwertspeichereinheiten zum Abspeichern von ermittelten Fehleradressen von fehlerhaften Datenspeichereinheiten, wobei jede Festwertspeichereinheit durch Anlegen von Eingabe-Testdaten und durch Vergleichen ausgelesener Ausgabetestdaten mit erwarteten Soll-Ausgabetestdaten auf ihre Funktionsfähigkeit überprüfbar ist, wobei jede Festwertspeichereinheit ein Adressen-BIT einer Fehleradresse abspeichert und die Festwertspeichereinheit einen Leseschaltkreis zum Auslesen des eingeschriebenen Adressen-BITs aufweist, wobei dem Leseschaltkreis ein Verriegelungsschaltkreis mit zwei rückgekoppelten Invertern nachgeschaltet ist und der Verriegelungsschaltkreis einen Multiplexer enthält.

Bevorzugte Ausführungsform des erfindungsgemäßen testbaren Festwertspeichers sind in den Unteransprüchen angegeben.

Der Festwertspeicher ist vorzugsweise zwischen einem Testbetrieb und einem Normalbetrieb umschaltbar.

Die Festwertspeichereinheit des Festwertspeichers weist vorzugsweise eine Schmelzsicherungseinrichtung zum nichtlöschbaren Einschreiben von Adressen-BITs auf.

Die Schmelzsicherungseinrichtung ist vorzugsweise ein schmelzbarer Wiederstand, der aus Metall oder Polysilizium besteht.

Der Multiplexer weist vorzugsweise einen Steueranschluss zum Umschalten zwischen dem Test- und dem Normalbetrieb des Festwertspeichers auf.

Dabei enthält der Multiplexer vorzugsweise einen ersten Dateneingang zum Anlegen von Testdaten.

Der Multiplexer weist vorzugsweise ferner einen zweiten Dateneingang auf, der mit dem Ausgang eines ersten Inverters des Verriegelungsschaltkreises verbunden ist.

Der Ausgang des Multiplexers ist vorzugsweise mit dem Eingang eines zweiten Inverters des Verriegelungsschaltkreises verbunden.

An dem zweiten Dateneingang des Multiplexers und an den Ausgang des ersten Inverters ist vorzugsweise ein Datenausgabepuffer angeschlossen.

Der Datenausgabepuffer gibt vorzugsweise die Daten an ein Abtast-Flipflop eines seriellen Schieberegisters aus.

Der Datenausgang des Abtast-Flipflops ist bei einer besonders bevorzugten Ausführungsform mit dem ersten Dateneingang des Multiplexers zum Anlegen von Testdaten verbunden.

Der erfindungsgemäße Festwertspeicher ist vorzugsweise mit einer Redundanz-Steuerlogik eines Datenspeichers verbunden, wobei der Datenspeicher einen Redundanz-Datenspeicher und einen Haupt-Datenspeicher enthält.

Die mit dem Festwertspeicher verbundene Redundanz-Steuerlogik weist vorzugsweise einen Redundanz-Adressenspeicher und zugehörigen Redundanz-Datenspeicher auf.

Die in dem erfindungsgemäßen Festwertspeicher abgespeicherten Fehleradressen sind vorzugsweise in den Redundanz-Adressenspeicher der Redundanz-Steuerlogik auslesbar.

Dabei besteht der Redundanz-Datenspeicher der Redundanz-Steuerlogik aus mehreren Redundanz-Datenspeichereinheiten zum Ersatz von fehlerhaften Datenspeichereinheiten innerhalb des Haupt-Datenspeichers.

Die Redundanz-Speichereinheiten des Redundanz-Datenspeichers innerhalb der Redundanz-Steuerlogik sind vorzugsweise Register.

Die Eingabe-Testdaten und die Soll-Ausgabetestdaten werden vorzugsweise durch eine in dem Datenspeicher integrierte Selbsttestlogik erzeugt.

Der testbare Festwertspeicher gemäß der Erfindung ist vorzugsweise ebenfalls in den Datenspeicher integriert.

Im weiteren werden bevorzugte Ausführungsform der erfindungsgemäßen testbaren Festwertspeichers unter Bezugnahme auf die beigefügten Figuren zur Erläuterung erfindungswesentlicher Merkmale beschrieben.

Es zeigt
- Fig. 1: eine Festwertspeicher nach dem Stand der Technik;
- Fig. 2: eine erste Ausführungsform einer Festwertspeichereinheit zum Aufbau des erfindungsgemäßen Festwertspeichers;
- Fig. 3: eine zweite Ausführungsform einer Festwertspeichereinheit zum Aufbau eines erfindungsgemäßen testbaren Festwertspeichers;
- Fig.4: den Aufbau eines erfindungsgemäßen Festwertspeichers aus mehreren Festwertspeichereinheiten;
- Fig. 5: den erfindungsgemäßen Festwertspeicher innerhalb eines Datenspeichers.

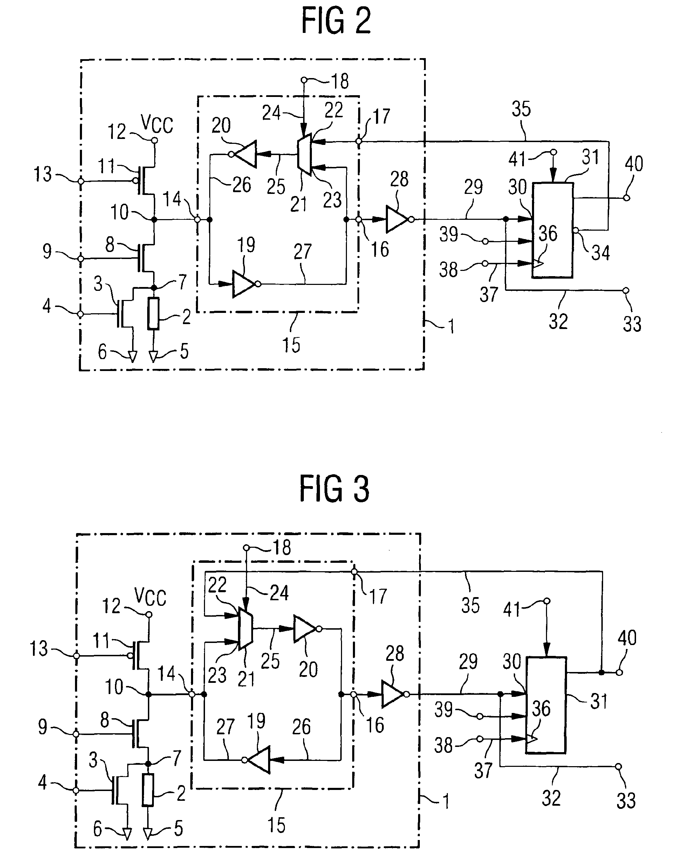

Fig. 2 stellt eine erste Ausführungsform einer erfindungsgemäßen Festwertspeichereinheit für eine testbaren Festwertspeicher dar.

Die Festwertspeichereinheit 1 enthält eine Schmelzsicherungseinrichtung 2, die aus einem schmelzbaren Widerstand aus Metall oder Polysilizium besteht.

Parallel zur Schmelzsicherungseinrichtung 2 ist ein erster MOSFET-Transistor 3 zum Anlegen eines Erdungs-Steuerungssignals an den Anschluss 4 des MOSFETs 3 geschaltet.

Die Schmelzsicherungseinrichtung 2 ist über einen Anschluss 5 und der MOSFET 3 über einen Anschluss 6 geerdet.

Der andere Anschluss 7 der Schmelzsicherungseinrichtung 2 ist mit dem parallel geschalteten MOSFET 3 direkt verbunden.

An dem Anschluss 7 liegt ein weiterer MOSFET 8 an, dessen Gate mit einem weiteren Anschluss 9 der Festwertspeichereinheit 1 verbunden ist. Durch Anlegen eines Steuersignals an den Anschluss 9 wird das in dem Potentialknoten 7 anliegende Spannungspotential über dem MOSFET 8 an den Potentialknoten 10 ausgelesen. Der Potentialknoten 10 ist über einen dritten MOSFET 11 an einen Versorgungsspannunganschluss 12 schaltbar.

Das Gate des dritten MOSFETs 11 liegt an einem weiteren Anschluss 13 der Festwertspeichereinheit 1 an. Der MOSFET 11 ist komplementär zu den beiden übrigen MOSFETs 3, 8 aufgebaut.

Bei der in Figur 2 dargestellten Ausführungsform ist der MOSFET 11 ein P-Kanal-MOSFET und die beiden übrigen MOSFETs 3, 8 sind N-Kanal-MOSFETs.

Durch Anlegen eines Steuersignals an den Steueranschluss 13 des P-Kanal-MOSFETs 11 kann die an den Potentialknoten 12 anliegende Versorgungsspannung zum Vorladen der Schmelzsicherungseinrichtung 2 auf den Potentialknoten 10 durchgeschaltet werden. Der Potentialknoten 10 ist mit dem Signaleingang 14 eines Verriegelungsschaltkreises 15 verbunden.

Der Verriegelungsschaltkreis 15 weist den Signaleingang 14, einen Signalausgang 16, einen Testdateneingang 17 sowie einen Steueranschluss 18 zum Umschalten der Betriebsart auf.

Der Verriegelungsschaltkreis 15 besteht aus zwei in einer Rückkopplungsschleife befindlichen rückgekoppelten Inverterschaltkreisen 19, 20 sowie einem Multiplexer 21, der zwischen zwei Dateneingängen 22, 23 gesteuert über eine Steuerleitung 24 umschaltbar ist. Die Steuerleitung 24 liegt an dem Steueranschluss 18 zum Umschalten den Betriebsart der Verriegelungsschaltung 15 an. Der Ausgang des Multiplexer 21 ist über eine Leitung 25 mit dem Eingang des Inverters 20 verbunden. Der Ausgang des Inverters 20 mit dem Eingang des Inverters 19 verbunden. Der Ausgang des Inverters 19 ist wiederum über eine Rückkoppelleitung 27 an den Dateneingang 23 des Multiplexer 21 angeschlossen.

Der Dateneingang 23 des Multiplexer 21 sowie der Ausgang des Inverters 19 sind direkt mit dem Signalausgang 16 der Verriegelungsschaltung 15 verbunden. Der Signalausgang 16 der Verriegelungsschaltung 15 liegt an einem Eingang eines Datenausgabepuffers 28. Der Datenausgabepuffer 28 besteht bei der in Figur 2 dargestellten Ausführungsform aus einem Inverterschaltkreis.

Der Datenausgabepuffer 28 gibt die an dem Signalausgang 16 des Verriegelungsschaltung 15 anliegenden Daten invertiert über eine Leitung 29 an einen Steueranschluss 30 eines Abtast-Flipflops 31 ab.

Das Abtast-Flipflop 31 bildet einen Teil eines seriellen Schieberegisters. Bei der in Figur 2 dargestellten Ausführungsform ist das Abtast-Flipflop ein D-Flipflop, dessen D-Eingang an der Leitung 29 anliegt.

Der an der Ausgabeleitung 29 anliegende logische Wert kann über eine Leitung 32 über einen Datenausgabeanschluss 33 ausgelesen werden. Ein Datenausgang 34 des Abtast-Flipflops 31 ist über eine Rückkoppelleitung 35 an den Testdateneingang 17 der Verriegelungsschaltung 15 rückgekoppelt. Das Abtast-Flipflop 31 besitzt ferner einen Takteingang 36, der über eine Taktleitung 37 mit einem Takteingangsanschluss 38 zum Anlegen eines Taktsignals verbunden ist.

Über einen Testdaten-Eingangsanschluss 39 können Testdaten in das Abtast-Flipflop 31 des seriellen Schieberegisters eingeschrieben werden.

Über einen Testdaten-Ausgabeanschluss 40 des Abtast-Flipflops 31 können Testdaten aus dem Abtast-Flipflops 31 des seriellen Schieberegisters ausgelesen werden.

Über einen Teststeueranschluss 41 wird gesteuert, ob der an dem Testdateneingang 39 anliegende Wert oder der am Eingang 30 anliegende logische Wert in dem Abtast-Flipflop 31 zwischengespeichert wird und am Datenausgang 34 des Abtast-Flipflops 31 anliegt.

Bei der in Fig. 2 dargestellten ersten Ausführungsform der erfindungsgemäßen Festwertspeichereinheit liegt am Ausgang 29 des Datenausgabepuffers 28 im Testbetrieb ein logischer Wert an, der invertiert zu demjenigen logischen Wert ist, welcher an dem Testdateneingang 17 der Verriegelungsschaltung 15 anliegt, wenn die Festwertspeichereinheit funktionstüchtig ist. Hierzu wird durch Anlegen eines Steuersignals an den Steueranschluss 18 des Multiplexers 21 auf den Dateneingang 22 umgeschaltet und Testdaten in die aus den beiden Invertern 19, 20 bestehende Rückkoppelschleife eingekoppelt. Von dort werden die eingekoppelten Testdaten durch den Datenausgabepuffer 28 invertiert an den Ausgang 29 ausgekoppelt und sind dann über den Datenausleseanschluss 33 auslesbar.

Da jedes am Anschluss 17 anliegende Testdatum eine ungerade Anzahl von Invertern, nämlich die Inverter 20, 19, 28 durchläuft, muß am Datenausleseanschluss 33 der zum Testdatum invertierte Wert ausgelesen werden, wenn die Festwertspeichereinheit 1 funktionstüchtig ist.

Im Normalbetrieb wird über den Steueranschluss 18 der Multiplexer 21 auf den anderen Dateneingang 23 umgeschaltet und somit die Rückkoppelschleife wieder geschlossen.

Zum Auslesen des in der Schmelzsicherungseinrichtung 2 eingespeicherten BITs wird der Auslese-MOSFET 8 durch Anlegen eines Steuersignals an den Gateanschluss 9 durchgeschaltet und der am Potentialknoten 10 anliegende logische Wert in der Rückkoppelschleife gehalten und über den Ausgabepuffer 28 an die Leitung 29 ausgelesen.

Fig. 3 zeigt eine weitere Ausführungsform der erfindungsgemäßen Festwertspeichereinheit 1. Bei dieser Ausführungsform werden die Testdaten über die Rückkoppelleitung 35 derart in die Rückkoppelschleife eingekoppelt, dass sie im Testbetrieb eine gerade Anzahl von Invertern durchlaufen, so dass im fehlerfreien Fall der am Datenausleseanschluss 33 anliegende logische Wert dem eingekoppelten Testdatenwert entspricht.

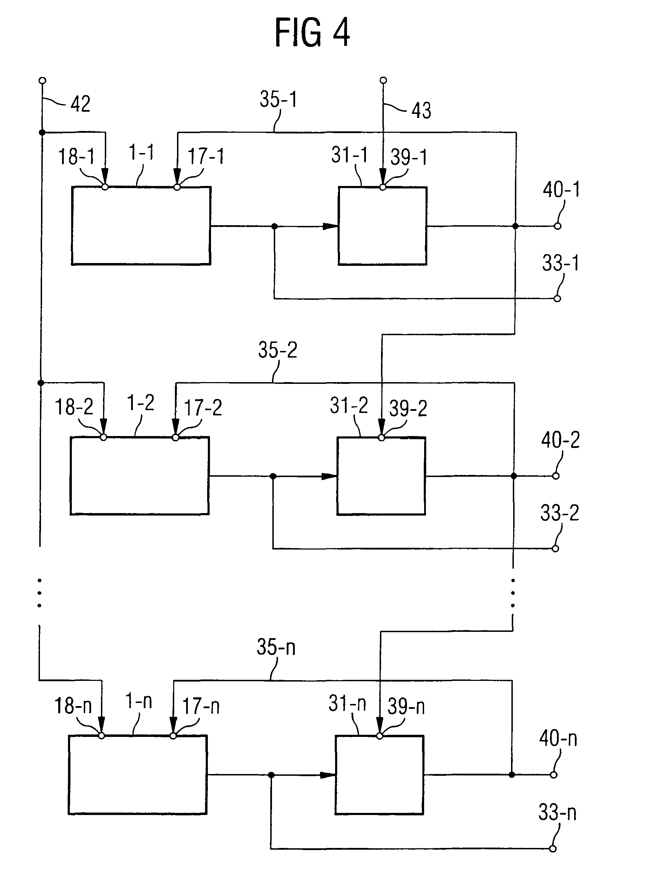

Fig. 4 zeigt den Aufbau eines vollständigen testbaren Festwertspeichers gemäß der Erfindung, der aus einer Vielzahl von Festwertspeichereinheit aufgebaut ist, wie sie in den Figuren 2, 3 dargestellt sind. Die Festwertspeichereinheiten 1-1 bis 1-N werden über eine gemeinsame Steuerleitung 42 zum Umschalten zwischen Test- und Nomalbetrieb angesteuert.

Die Steuerleitung 42 liegt an den Teststeueranschlüssen 18-8N an.

Die Abtast-Flipflops 31-1, 31-N bilden ein serielles Schieberegister, wobei Testdaten in den Testeingang 39-1 des ersten Abtast-Flipflops 31-1 über eine Datenleitung 43 eingeschoben werden. Die Testdateneingänge 39-2 bis 39-N der nachgeschalteten Abtast-Flipflops 31-2 bis 31-N sind jeweils mit dem Testdatenausgang 40 des vorangehenden Abtast-Flipflops verbunden.

Der testbare Festwertspeicher wird durch die Festwertspeichereinheiten 1-1 bis 1-N gebildet. Zum Test des Festwertspeichers gemäß der Erfindung werden die Festwertspeichereinheiten über die Steuerleitung 42 zunächst in den Testbetrieb umgeschaltet und anschließend werden Testdaten in das serielle Schieberegister eingeschrieben.

In einem weiteren Schritt werden Ausgabetestdaten über die Testdatenausleseanschlüsse 33-1 bis 33-N ausgelesen und die ausgelesenen Testdaten mit erwarteten Soll-Testdaten verglichen. Stimmen die ausgelesenen Ausgabetestdaten mit erwarteten Soll-Ausgabetestdaten überein, ist der Festwertspeicher 1 funktionsfähig. Stimmen die ausgelesenen Ausgabetestdaten und die erwarteten Soll-Ausgabetestdaten nicht überein, ist der testbare Festwertspeicher nicht funktionsfähig. Es erfolgt eine Fehlerbehandlung.

Ist der Festwertspeicher aus Festwertspeichereinheiten 1 aufgebaut, die den in Fig. 2 dargestellten Aufbau besitzen, durchlaufen die Testdaten eine ungerade Anzahl von Invertern im Testbetrieb, so dass das Ausgabe-Testmuster zu dem invertierten Eingabe-Testmuster entspricht, wenn die Festwertspeichereinheiten 1 fehlerfrei arbeiten.

Ist der testbare Festwertspeicher aus Festwertspeichereinheiten 1 aufgebaut, die den in Fig. 3 dargestellten Aufbau besitzen, ist das ausgelesene Ausgabe-Testdatenmuster identisch zu dem Eingabe-Testdatenmuster, sofern die Festwertspeichereinheiten alle völlig fehlerfrei arbeiten.

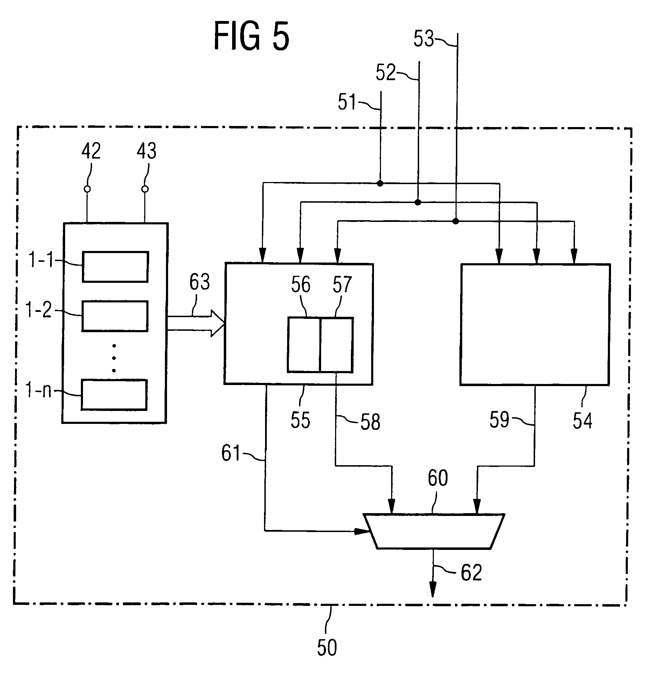

Fig. 5 zeigt eine Datenspeichereinheit 50, bei der ein testbarer Festwertspeicher gemäß der Erfindung eingebaut ist.

Der testbare Festwertspeicher gemäß der Erfindung besteht aus mehreren Festwertspeichereinheiten 1-1 bis 1-N. Jede Festwertspeichereinheit 1 ist in der Lage, ein BIT einer fehlerhaften Adresse abzuspeichern. Der Datenspeicher 50 ist an einen Adressenbus 51, einen Datenbus 52 und an einen Steuerbus 53 angeschlossen. Dabei weist der Datenspeicher 50 eine Haupt-Datenspeicher 54 und eine dazu parallel geschaltete Redundanz-Steuerlogik 55 auf.

Die Redundanz-Steuerlogik 55 enthält einen Redundanz-Adressenspeicher 56 und einen Redundanz-Datenspeicher 57. Dabei weist der Redundanz-Adressenspeicher 56 mehrere Redundanz-Adressenspeichereinheiten auf, der jeweils eine Redundanz-Datenspeichereinheit innerhalb des Redundanz-Adressenspeichers 57 zugeordnet ist. In dem Festwertspeicher befinden sich die Adressen der innerhalb des Haupt-Datenspeichers 54 als fehlerhaft erkannten Datenspeichereinheiten.

Der Redundanz-Datenspeicher 57 und der Haupt-Datenspeicher 54 sind über Datenleitungen 58, 59 mit einem Multiplexer 60 verbunden, der von der Redundanz-Steuerlogik 55 über eine Steuerleitung 61 gesteuert wird. Der Multiplexer 60 weist Datenausgangsleitungen 62 auf, die in Abhängigkeit von dem an der Leitung 61 anliegenden Steuersignal zwischen den Datenleitungen 58 und den Datenleitungen 59 geschaltet werden.

Bei einem Stromausfall werden die in dem Festwertspeicher gespeicherten Adressen über Adressenleitungen 63 in die Redundanz-Adressenspeichereinheiten des Redundanz-Adressenspeichers 56 geladen. Bei einem Datenzugriff auf eine derartige Fehleradresse wird nicht auf die fehlerhafte Datenspeichereinheit innerhalb des Haupt-Datenspeichers 54 sondern auf die zugehörigen Redundanz-Datenspeichereinheit innerhalb des Redundanz-Datenspeichers 57 zugegriffen. Die Adressenleitungen 63 sind mit den Datenausgabeanschlüssen 33-1 bis 33-N des Festwertspeichers verbunden.

Der Festwertspeicher wird über den Steueranschluss 42 zwischen Normalbetrieb und Testbetrieb umgeschaltet. Im Testbetrieb wird der Festwertspeicher durch Anlegen eines Testdatenmuster an den Festdateneingang 43, durch Einschreiben eines Testdatenmusters und durch anschließendes Auslesen eines Testdatenausgabemusters getestet, wobei das ausgelesene Ausgabetestdatenmuster mit einem Soll-Ausgabetestdatenmuster verglichen wird.

Im Normalbetrieb werden die in dem Festwertspeicher abgespeicherten Adressen, beispielsweise nach einem Stromausfall, in den Redundanz-Adressenspeicher 56 der Redundanz-Steuerlogik 55 geladen.

Das Eingabe-Testdatenmuster und die Soll-Ausgabetestdatenmuster werden vorzugsweise durch einen in Datenspeicher 50 integrierte Selbsttestlogik erzeugt und ausgewertet.

Alternativ dazu können die Eingabe-Testdatenmuster sowie die Soll-Ausgabetestdatenmuster auch in einem angeschlossenen Testautomaten erzeugt bzw. ausgewertet werden.

Ein Vorteil erfindungsgemäßen der testbaren Festwertspeichers besteht darin, dass der Festwertspeicher ohne Brennen der Schmelzsicherungseinrichtung 2 auf seine Funktionsfähigkeit getestet werden kann. Das Brennen der Schmelzsicherungseinrichtungen erfolgt erst nach dem die Funktionsfähigkeit des Verriegelungsschaltkreises 15 und des Datenausgabepuffers 28 im Testbetrieb festgestellt worden ist. Der erfindungsgemäße testbare Festwertspeicher stellt eine fehlerfreie Umadressierung von fehlerhaft erkannten Datenspeichereinheiten innerhalb der Haupt-Datenspeichers 54 sicher. Zum Erkennen eines Fehlers in dem testbaren Festwertspeichers erfolgt eine Fehlerbehandlung, wobei auf ein Brennen der Schmelzsicherungseinrichtungen 2 innerhalb fehlerhaft erkannter Festwertspeichereinheiten 1 verzichtet wird.

Hierdurch kommt es zu einer erheblichen Zeitersparnis, da ein fehlerhafter Festwertspeicher nicht erst nach dem zeitintensiven Brennvorgang erkannt wird, sondern bereits vor dem Brennen der Schmelzsicherungseinrichtungen.

### Bezugszeichenliste:

- 1: Festwertspeichereinheit
- 2: Schmelzsicherungseinrichtung
- 3: MOSFET
- 4: Anschluß
- 5: Masse
- 6: Masse
- 7: Potentialnoten
- 8: MOSFET
- 9: Anschluß
- 10: Potentialnoten
- 11: MOSFET
- 12: Versorgungsspannung
- 13: Anschluß
- 14: Anschluß
- 15: Regelungsschaltung
- 16: Anschluß
- 17: Festdateneingang
- 18: Betriebsartsteueranschluß
- 19: Inverter
- 20: Inverter
- 21: Multiplexer
- 22: Dateneingang
- 23: Dateneingang
- 24: Leitung
- 25: Leitung
- 26: Leitung
- 27: Leitung
- 28: Datenausgabepuffer
- 29: Leitung
- 30: Flipflop-Dateneingang
- 31: Abtast-Flipflop
- 32: Leitung
- 33: Datenausleseanschluß
- 34: Flipflop-Datenausgang
- 35: Rückkoppelleitung
- 36: Takteingang
- 37: Leitung
- 38: Taktanschluß
- 39: Testdateneingang
- 40: Testdatenausgang
- 41: Steueranschluß
- 42: Betriebsart-Umschaltanschluß
- 43: Testdateneingabeleitung
- 50: Datenspeicher
- 51: Adreßbus
- 52: Datenbus
- 54: Haupt-Datenspeicher
- 55: Redundanz-Steuerlogik
- 56: Redundanz-Adressenspeicher
- 57: Redundanz-Datenspeicher
- 58: Datenleitungen
- 59: Datenleitungen
- 60: Muliplexer
- 61: Steuerleitung
- 62: Datenausgabeleitungen
- 63: Adreßleitungen

## Patentansprüche

1. Testbarer Festwertspeicher für eine Datenspeicher-Redundanzlogik (55) mit Festwertspeichereinheiten (1) zum Abspeichern von ermittelten Fehleradressen von fehlerhaften Datenspeichereinheiten,
wobei jede Festwertspeichereinheit (1) durch Anlegen von Eingabe-Testdaten und durch Vergleich ausgelesener Ausgabe-Testdaten mit erwarteten Soll-Ausgabe-Testdaten auf ihre Funktionsfähigkeit überprüfbar ist,
wobei jede Festwertspeichereinheit (1) ein Adressen-BIT einer Fehleradresse abspeichert und die Festwertspeichereinheit (1) einen Leseschaltkreis zum Auslesen des eingeschriebenen Adressen-BITs aufweist;
wobei dem Leseschaltkreis ein Verriegelungsschaltkreis (15) mit zwei rückgekoppelten Invertern (19, 20) nachgeschaltet ist
**dadurch gekennzeichnet,**
**dass** der Verriegelungsschaltkreis (15) einen Multiplexer (21) enthält.

2. Testbarer Festwertspeicher nach Anspruch 1,
**dadurch gekennzeichnet,**
**dass** der Festwertspeicher zwischen einem Testbetrieb und einem Normalbetrieb umschaltbar ist.

3. Testbarer Festwertspeicher nach einem der vorangehenden Ansprüchen,
**dadurch gekennzeichnet,**
**dass** die Festwertspeichereinheit (1) eine Schmelzsicherungseinrichtung (2) zum nicht-löschbaren Einschreiben eines Adressen-BITs aufweist.

4. Testbarer Festwertspeicher nach einem der vorangehenden Ansprüchen,
**dadurch gekennzeichnet,**
**dass** die Schmelzsicherungseinrichtung (2) ein schmelzbarer Widerstand aus Metall oder Polysilizium ist.

5. Testbarer Festwertspeicher nach einem der vorangehenden Ansprüchen,
**dadurch gekennzeichnet,**
**dass** der Multiplexer (21) einen Steueranschluss (18) zum Umschalten zwischen dem Test- und dem Normalbetrieb aufweist.

6. Testbarer Festwertspeicher nach einem der vorangehenden Ansprüchen,
**dadurch gekennzeichnet,**
**dass** der Multiplexer (21) einen ersten Dateneingang (22) zum Anlegen von Testdaten aufweist.

7. Testbarer Festwertspeicher nach einem der vorangehenden Ansprüchen,
**dadurch gekennzeichnet,**
**dass** der Multiplexer (21) einen zweiten Dateneingang (23) aufweist, der mit dem Ausgang eines ersten Inverters (19) des Verriegelungsschaltkreis (15) verbunden ist.

8. Testbarer Festwertspeicher nach einem der vorangehenden Ansprüchen,
**dadurch gekennzeichnet,**
**dass** der Ausgang des Multiplexers (21) mit dem Eingang eines zweiten Inverters (20) des Verriegelungsschaltkreis (15) verbunden ist.

9. Testbarer Festwertspeicher nach einem der vorangehenden Ansprüchen,
**dadurch gekennzeichnet,**
**dass** an dem zweiten Dateneingang (23) des Multiplexers (21) und dem Ausgang des ersten Inverters (19) ein Datenausgabepuffer (28) angeschlossen ist.

10. Testbarer Festwertspeicher nach einem der vorangehenden Ansprüchen,
**dadurch gekennzeichnet,**
**dass** der Datenausgabepuffer (28) die Daten an ein Abtast-Flipflop (31) eines seriellen Schieberegisters ausgibt.

11. Testbarer Festwertspeicher nach einem der vorangehenden Ansprüchen,
**dadurch gekennzeichnet,**
**dass** der Datenausgang (34) des Abtast-Flipflops mit dem ersten Dateneingang (22) des Multiplexers (21) zum Anlegen von Testdaten verbunden ist.

12. Testbarer Festwertspeicher nach einem der vorangehenden Ansprüchen,
**dadurch gekennzeichnet,**
**dass** der Festwertspeicher mit einer Redundanz-Steuerlogik (55) eines Datenspeichers (50) verbunden ist, der einen Redundanz-Datenspeicher (57) und einen Haupt-Datenspeicher (54) enthält.

13. Testbarer Festwertspeicher nach einem der vorangehenden Ansprüchen,
**dadurch gekennzeichnet,**
**dass** die Redundanz-Steuerlogik (55) einen Redundanz-Adressenspeicher (56) und den Redundanz-Datenspeicher (57) aufweist.

14. Testbarer Festwertspeicher nach einem der vorangehenden Ansprüchen,
**dadurch gekennzeichnet,**
**dass** die in dem Festwertspeicher abgespeicherten Fehleradressen in den Redundanz-Adressenspeicher (56) der Redundanz-Steuerlogik (55) auslesbar sind.

15. Testbarer Festwertspeicher nach einem der vorangehenden Ansprüchen,
**dadurch gekennzeichnet,**
**dass** der Redundanz-Datenspeicher (57) aus mehreren Redundanz-Datenspeichereinheiten zum Ersatz von fehlerhafte Datenspeichereinheiten innerhalb des Haupt-Datenspeichers (54) besteht.

16. Testbarer Festwertspeicher nach einem der vorangehenden Ansprüchen,
**dadurch gekennzeichnet,**
**dass** die Redundanz-Adressenspeichereinheiten Register sind.

17. Testbarer Festwertspeicher nach einem der vorangehenden Ansprüchen,
**dadurch gekennzeichnet,**
**dass** die Eingabetestdaten und die Soll-Ausgabetestdaten durch eine in dem Datenspeicher (50) integrierte Selbsttestlogik erzeugt werden.

## Claims

1. Testable read-only memory for data memory redundant logic (55) having read-only memory units (1) for the storage of determined fault addresses of faulty data memory units,
in which case the serviceability of each read-only memory unit (1) can be checked by application of input test data and by comparison of read output test data with expected nominal output test data,
in which case each read-only memory unit (1) stores one address BIT of a fault address and the read-only memory unit (1) has a read circuit for reading the written address BIT;
in which case a latching circuit (15) with two feedback inverters (19, 20) is connected downstream from the read circuit, **characterized in that** the latching circuit (15) contains a multiplexer (21).

2. Testable read-only memory according to Claim 1, **characterized in that** the read-only memory can be switched between a test mode and a normal mode.

3. Testable read-only memory according to one of the preceding claims, **characterized in that** the read-only memory unit (1) has a fuse link device (2) for non-erasable writing of an address BIT.

4. Testable read-only memory according to one of the preceding claims, **characterized in that** the fuse link device (2) is a fusible resistor composed of metal or polysilicon.

5. Testable read-only memory according to one of the preceding claims, **characterized in that** the multiplexer (21) has a control connection (18) for switching between the test mode and the normal mode.

6. Testable read-only memory according to one of the preceding claims, **characterized in that** the multiplexer (21) has a first data input (22) for application of test data.

7. Testable read-only memory according to one of the preceding claims, **characterized in that** the multiplexer (21) has a second data input (23), which is connected to the output of a first inverter (19) in the latching circuit (15).

8. Testable read-only memory according to one of the preceding claims, **characterized in that** the output of the multiplexer (21) is connected to the input of a second inverter (20) in the latching circuit (15).

9. Testable read-only memory according to one of the preceding claims, **characterized in that** a data output buffer (28) is connected to the second data input (23) of the multiplexer (21) and to the output of the first inverter (19).

10. Testable read-only memory according to one of the preceding claims, **characterized in that** the data output buffer (28) outputs the data to a sampling flipflop (31) in a serial shift register.

11. Testable read-only memory according to one of the preceding claims, **characterized in that** the data output (34) of the sampling flipflop is connected to the first data input (22) of the multiplexer (21) for application of test data.

12. Testable read-only memory according to one of the preceding claims, **characterized in that** the read-only memory is connected to redundant control logic (55) in a data memory (50), which contains a redundant data memory (57) and a main data memory (54).

13. Testable read-only memory according to one of the preceding claims, **characterized in that** the redundant control logic (55) has a redundant address memory (56) and the redundant data memory (57) .

14. Testable read-only memory according to one of the preceding claims, **characterized in that** the fault addresses stored in the read-only memory can be read to the redundant address memory (56) in the redundant control logic (55).

15. Testable read-only memory according to one of the preceding claims, **characterized in that** the redundant data memory (57) comprises a plurality of redundant data memory units for replacement of faulty data memory units within the main data memory (54).

16. Testable read-only memory according to one of the preceding claims, **characterized in that** the redundant address memory units are registers.

17. Testable read-only memory according to one of the preceding claims, **characterized in that** the input test data and the nominal output test data are produced by self-test logic integrated in the data memory (50).

## Revendications

1. Mémoire morte testable pour une logique redondante de mémoire de données (55) comprenant des unités de mémoire morte (1) pour enregistrer des adresses d'erreur détectées d'unités de mémoire de données erronées,
chaque unité de mémoire morte (1) étant contrôlable par rapport à sa capacité de fonctionner par application de données de test d'entrée et par comparaison de données de test de sortie lues avec des données de test de sortie théoriques attendues,
chaque unité de mémoire morte (1) mémorise un bit d'adresse d'une adresse d'erreur et l'unité de mémoire morte (1) comprend un circuit de lecture pour lire le bit d'adresse enregistré ;
un circuit de verrouillage (15) avec deux inverseurs (19, 20) rétroactifs étant connecté en aval du circuit de lecture,
**caractérisée en ce que**
le circuit de verrouillage (15) contient un multiplexeur (21).

2. Mémoire morte testable selon la revendication 1,
**caractérisée en ce que**
la mémoire morte est commutable entre un mode de fonctionnement de test et un mode de fonctionnement normal.

3. Mémoire morte testable selon l'une quelconque des revendications précédentes
**caractérisée en ce que**
l'unité de mémoire morte (1) comprend un dispositif fusible (2) pour l'écriture non effaçable d'un bit d'adresse.

4. Mémoire morte testable selon l'une quelconque des revendications précédentes
**caractérisée en ce que**
le dispositif fusible (2) est une résistance fusible en métal ou en poly-silicium.

5. Mémoire morte testable selon l'une quelconque des revendications précédentes
**caractérisée en ce que**
le multiplexeur (21) comprend une borne de commande (18) pour commuter entre le mode de fonctionnement de test et le mode de fonctionnement normal.

6. Mémoire morte testable selon l'une quelconque des revendications précédentes
**caractérisée en ce que**
le multiplexeur (21) comprend une première entrée de données (22) pour l'application de données de test.

7. Mémoire morte testable selon l'une quelconque des revendications précédentes
**caractérisée en ce que**
le multiplexeur (21) comprend une deuxième entrée de données (23) qui est reliée avec la sortie d'un premier inverseur (19) du circuit de verrouillage (15).

8. Mémoire morte testable selon l'une quelconque des revendications précédentes
**caractérisée en ce que**
la sortie du multiplexeur (21) est reliée avec l'entrée d'un deuxième inverseur (20) du circuit de verrouillage (15).

9. Mémoire morte testable selon l'une quelconque des revendications précédentes
**caractérisée en ce qu'**
un buffer de sortie de données (28) est raccordé à la deuxième entrée de données (23) du multiplexeur (21) et à la sortie du premier inverseur (19).

10. Mémoire morte testable selon l'une quelconque des revendications précédentes
**caractérisée en ce que**
le buffer de sortie de données (28) délivre les données à un flip-flop d'échantillonnage (31) d'un registre à décalage sériel.

11. Mémoire morte testable selon l'une quelconque des revendications précédentes
**caractérisée en ce que**
la sortie de données (34) du flip-flop d'échantillonnage est reliée avec la première entrée de données (22) du multiplexeur (21) pour l'application de données de test.

12. Mémoire morte testable selon l'une quelconque des revendications précédentes
**caractérisée en ce que**
la mémoire morte est reliée avec une logique de commande redondante (55) d'une mémoire de données (50) qui contient une mémoire de données (57) redondante et une mémoire de données principale (54).

13. Mémoire morte testable selon l'une quelconque des revendications précédentes
**caractérisée en ce que**
la logique de commande redondante (55) comprend une mémoire d'adresses redondante (56) et la mémoire de données redondante (57).

14. Mémoire morte testable selon l'une quelconque des revendications précédentes
**caractérisée en ce que**
les adresses d'erreur mémorisées dans la mémoire morte peuvent être extraites vers la mémoire d'adresses redondante (56) de la logique de commande redondante (55).

15. Mémoire morte testable selon l'une quelconque des revendications précédentes
**caractérisée en ce que**
la mémoire de données redondante (57) est constituée de plusieurs unités de mémoire de données redondantes pour le replacement d' unités de mémoire de données erronées à l'intérieur de la mémoire de données principale (54).

16. Mémoire morte testable selon l'une quelconque des revendications précédentes
**caractérisée en ce que**
les unités de mémoire d'adresses redondantes sont des registres.

17. Mémoire morte testable selon l'une quelconque des revendications précédentes
**caractérisée en ce que**
les données de test d'entrée et les données de test de sortie théoriques sont générées par une logique d'autotest intégrée dans la mémoire de données (50).
